(19) Europäisches Patentamt / European Patent Office / Office européen des brevets

(11) **EP 2 818 896 A2**

(12) **EUROPEAN PATENT APPLICATION**

(43) Date of publication:
**31.12.2014 Bulletin 2015/01**

(51) Int Cl.:
***G01V 1/28*** (2006.01)

(21) Application number: **14174732.9**

(22) Date of filing: **27.06.2014**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **28.06.2013 US 201313930702**

(71) Applicant: **BAKER HUGHES INCORPORATED
Houston TX 77210-4740 (US)**

(72) Inventors:
• **Zhang, Xiaomei**
  **Houston, TX Texas 77019-2118 (US)**
• **Holland, Marc**
  **Houston, TX Texas 77019-2118 (US)**
• **Van der Zee, Wouter**
  **Houston, TX Texas 77019-2118 (US)**

(74) Representative: **Mabey, Katherine Frances
Dehns
St Bride's House
10 Salisbury Square
London EC4Y 8JD (GB)**

(54) **Method and apparatus for estimating a parameter of a subsurface volume**

(57) A method for estimating a volume of a stimulated reservoir includes receiving a seismic signal having a magnitude from each detected microseismic event in a plurality of detected microseismic events in an earth formation to provide detected microseismic event information. The seismic signal is received by an array of seismic receivers (5A,5B). The method further includes estimating a number of undetected microseismic events and a magnitude for each of the undetected microseismic events to provide undetected microseismic event information where the number of undetected microseismic events and corresponding magnitudes are estimated using each of the detected microseismic events and corresponding magnitudes. The method further includes estimating the stimulated reservoir volume using the detected microseismic event information and the undetected microseismic event information.

FIG.9

EP 2 818 896 A2

## Description

### BACKGROUND

Hydraulic fracturing of rock in earth formations is a technique used to extract hydrocarbons from reservoirs in the formations. Fracturing increases the number of fractures in the rock or opens existing fractures to enhance permeability in the formation that in turn may increase the production rate and/or fluid conductivity of the formation. Geophones may be used to detect the location and magnitude of each of the ruptures caused by fracturing in order to calculate a reservoir volume stimulated by the process. Unfortunately, many of the ruptures may not be detected by the geophones leading to underestimating the stimulated reservoir volume and, thus, an amount of reservoir hydrocarbons that may be produced. Since the production of hydrocarbons can be expensive, it would be well received in the oil and gas industries if a method could be developed to calculate a stimulated reservoir volume that accounts for undetected microseismic events. Other industries such as the geothermal industry may also benefit from this method and apparatus. The invention is more generally applicable to estimating a parameter of a subsurface volume.

### BRIEF SUMMARY

In accordance with a first aspect of the invention there is provided a method for estimating a parameter of a subsurface volume, the method comprising:

> receiving a seismic signal having an amplitude from each event in a plurality of subsurface events, the seismic signal being received by a seismic receiver;
> estimating undetected events and an attribute for each of the undetected events, the undetected events and corresponding attributes being estimated using the seismic signal and corresponding amplitude; and
> estimating the parameter using the seismic signal and the corresponding attributes of the undetected events;
> wherein each of the estimating undetected events and the estimating the parameter is performed using one or more processors.

Estimating undetected events may comprise selecting a mathematical relationship relating a microseismic event magnitude to a number of microseismic events. The undetected events may be estimated from a range of points on a curve of the mathematical relationship where data comprising a number of events and corresponding magnitude received from the seismic signal departs from the curve. The relationship may relate the microseismic event magnitude to a cumulative number of microseismic events occurring at magnitudes that are greater than or equal to the microseismic event magnitude. The relationship may comprise:

$$\log(N) = a + b \cdot M_w$$

where $M_w$ represents a moment magnitude of a microseismic event, N represents a cumulative number of microseismic events having a moment magnitude greater than or equal to $M_w$, a represents a constant, and b represents a coefficient.

In accordance with the invention in any of its embodiments the method may further comprise:

> calculating a scalar attribute for each of the events in the plurality using the amplitude of the corresponding seismic signal; and
> calculating the scalar attribute for each of the estimated undetected events using the estimated attribute. The scalar attribute may be a scalar seismic moment ($M_0$). The method may further comprise:
>
>> determining a moment magnitude ($M_w$) from the magnitude of each of the detected and undetected events; and
>> calculating the scalar seismic moment ($M_0$) for each of the detected and undetected events using the corresponding moment magnitude ($M_w$). Calculating the scalar seismic moment ($M_0$) for each of the detected and undetected events may comprise using the following equation:

$$M_w = (2/3)\log M_0 - 6.0.$$

In any of the embodiments in which scalar attributes are determined for the detected and undetected events, estimating the parameter may comprise summing each of the scalar attributes corresponding to the detected and undetected events.

In accordance with the invention in any of its embodiments the method may further comprise:

> dividing the earth formation into a plurality of grid cells in a three-dimensional space;
> assigning each event to a grid cell based on location information derived from the seismic signal;
> estimating a number of undetected events and a magnitude for each of the undetected events to provide undetected event information for each grid cell, the number of undetected events and corresponding magnitudes for each grid cell being estimated using each of the detected events and corresponding amplitudes assigned to each grid cell;
> calculating a scalar attribute for each of the detected events in each grid cell using the amplitude of the corresponding seismic signal; and

calculating the scalar attribute for each of the estimated undetected events in each grid cell using the corresponding estimated magnitude. The method may further comprise summing the scalar attributes for each of the detected and undetected events in each grid cell to provide a grid cell scalar attribute. The method may further comprise summing each grid cell scalar attribute for each of the grid cells in the plurality of grid cells to estimate the parameter. In embodiments in which a grid cell scalar attribute is obtained for each grid cell, the method may further comprise displaying on a display the grid cell scalar attribute for each of the grid cells in the three-dimensional space. In accordance with any of the embodiments in which scalar attributes for each of the detected and undetected events in each of the grid cells are obtained, the method may further comprise summing the scalar attributes for each of the detected and undetected events in each of the grid cells in the plurality of grid cells to estimate the parameter.

In accordance with the invention, in any of its embodiments, the method may further comprise estimating a permeability of the subsurface volume using the seismic signal and the corresponding attributes of the undetected events, wherein the permeability is proportional to a scalar attribute representing reservoir deformation.

The method may further comprise stimulating an earth formation using a stimulation apparatus configured to generate a plurality of events in the formation. This step may be carried out prior to the step of receiving the seismic signal from each event in a plurality of subsurface events.

In accordance with a second aspect of the invention, there is provided method for estimating a parameter of a subsurface volume, the method comprising:

stimulating an earth formation using a stimulation apparatus configured to generate a plurality of events in the formation;
receiving a seismic signal having an amplitude from each event in a plurality of subsurface events, the seismic signal being received by a seismic receiver;
estimating undetected events and an attribute for each of the undetected events, the undetected events and corresponding attributes being estimated using the seismic signal and corresponding amplitudes; and
estimating the parameter using the seismic signal and the corresponding attributes of the undetected events;
wherein each of the estimating undetected events and the estimating the parameter is performed using one or more processors.

The present invention extends to a non-transitory computer readable medium comprising computer executable instructions for estimating a parameter of a subsurface volume in accordance with the method of the invention in any of its aspects or embodiments.

In accordance with a third aspect of the invention, there is provided a non-transitory computer readable medium comprising computer executable instructions for estimating a parameter of a subsurface volume that when executed by a computer implements a method comprising:

receiving a seismic signal having an amplitude from each event in a plurality of subsurface events, the seismic signal being received by a seismic receiver; estimating undetected events and an attribute for each of the undetected events, the events and corresponding attributes being estimated using the seismic signal and corresponding amplitudes; and estimating the parameter using the seismic signal and the corresponding attributes of the undetected events.

The present invention in accordance with the second and third aspects may include any of the features described by reference to the first. In general, the present invention in accordance with any aspect of the invention may include any or all of the features described in relation to another aspect of the invention to the extent that they are not mutually exclusive.

In accordance with any of the aspects or embodiments of the invention the parameter of the subsurface volume may be a volume of a reservoir. The reservoir may be a stimulated reservoir. Each event in the plurality of subsurface events may be a microseismic event and each undetected event may be an undetected microseismic event.

The present invention in accordance with any of its aspects or embodiments may comprise one or more of the following features. The attribute of each undetected subsurface event may be a magnitude. The seismic receiver may comprise or be an array of seismic receivers. The estimating undetected events, estimating the parameter and receiving a seismic signal may be carried out using the same processor. The receiving of the seismic signal may be carried out using the or a set of one or more processors.

It will be appreciated that in accordance with the invention, each subsurface event of the plurality of subsurface events from which a seismic signal is received by the seismic receiver may be referred to as a detected event.

In accordance with a fourth aspect of the invention there is provided a method for estimating a volume of a stimulated reservoir, the method comprising:

receiving, using a processor, a seismic signal having a magnitude from each detected microseismic event in a plurality of detected microseismic events in an earth formation to provide detected microseismic event information, the seismic signal being received by an array of seismic receivers;

estimating, using the processor, a number of undetected microseismic events and a magnitude for each of the undetected microseismic events to provide undetected microseismic event information, the number of undetected microseismic events and corresponding magnitudes being estimated using each of the detected microseismic events and corresponding magnitudes; and

estimating, using the processor, the stimulated reservoir volume using the detected microseismic event information and the undetected microseismic event information.

Estimating the number of undetected events may comprise selecting a mathematical relationship relating a microseismic event magnitude to a number of microseismic events. The number of undetected microseismic events may be estimated from a range of points on a curve of the mathematical relationship where data comprising a number of events and corresponding magnitude received from the seismic signal departs from the curve. The relationship may relate the microseismic event magnitude to a cumulative number of microseismic events occurring at magnitudes that are greater than or equal to the microseismic event magnitude. The relationship may comprise:

$$\log(N) = a + b \cdot M_w$$

where $M_w$ represents a moment magnitude of a microseismic event, N represents a cumulative number of microseismic events having a moment magnitude greater than or equal to $M_w$, a represents a constant, and b represents a coefficient.

In accordance with any of the embodiments of the method in its fourth aspect, the method may further comprise:

calculating a scalar attribute for each of the detected microseismic events using the magnitude of the corresponding seismic signal; and
calculating the scalar attribute for each of the estimated undetected microseismic events using the estimated magnitude.

The scalar attribute may be a scalar seismic moment ($M_0$). The method may further comprise:

determining a moment magnitude ($M_w$) from the magnitude of each of the detected and undetected microseismic events; and
calculating the scalar seismic moment ($M_0$) for each of the detected and undetected microseismic events using the corresponding moment magnitude ($M_w$).

Calculating the scalar seismic moment ($M_0$) for each of the detected and undetected microseismic events may comprise using the following equation:

$$\mathrm{Mw} = (2/3)\log M_0 - 6.0.$$

Estimating the stimulated reservoir volume may comprise summing each of the scalar attributes corresponding to the detected and undetected microseismic events.

In accordance with any of the embodiments of the fourth aspect of the invention, the method may further comprise:

dividing the earth formation into a plurality of grid cells in a three-dimensional space;
assigning each microseismic event to a grid cell based on location information derived from the seismic signal;
estimating a number of undetected microseismic events and a magnitude for each of the undetected microseismic events to provide undetected microseismic event information for each grid cell, the number of undetected microseismic events and corresponding magnitudes for each grid cell being estimated using each of the detected microseismic events and corresponding magnitudes assigned to each grid cell;
calculating a scalar attribute for each of the detected microseismic events in each grid cell using the magnitude of the corresponding seismic signal; and
calculating the scalar attribute for each of the estimated undetected microseismic events in each grid cell using the corresponding estimated magnitude.

The method in these embodiments may further comprise summing the scalar attributes for each of the detected and undetected microseismic events in each grid cell to provide a grid cell scalar attribute. The method may further comprise summing each grid cell scalar attribute for each of the grid cells in the plurality of grid cells to estimate the stimulated reservoir volume. In any of the embodiments in which a grid cell scalar attribute is obtained for each grid cell, the method may comprise displaying on a display the grid cell scalar attribute for each of the grid cells in the three-dimensional space.

In any of the embodiments in which scalar attributes are obtained for each of the detected and undetected microseismic events, the method may further comprise summing the scalar attributes for each of the detected and undetected microseismic events in each of the grid cells in the plurality of grid cells to estimate the stimulated reservoir volume.

In accordance with the fourth aspect of the invention in any of its embodiments the method may further comprise estimating a permeability of the reservoir using the detected microseismic event information and the undetected microseismic event information, wherein the permeability is proportional to a scalar attribute representing reservoir deformation.

The invention in this fourth aspect in any of its embodiments may further comprise stimulating an earth formation using a stimulation apparatus configured to generate a plurality of microseismic events in the formation. This step may be carried out prior to receiving a seismic signal from each detected microseismic event in the plurality of detected microseismic events in the earth formation.

In accordance with a fifth aspect of the invention there is provided a method for estimating a volume of a stimulated reservoir, the method comprising:

stimulating an earth formation using a stimulation apparatus configured to generate a plurality of microseismic events in the formation;
receiving, using a processor, a seismic signal having a magnitude from each detected microseismic event in a plurality of detected microseismic events in the earth formation to provide detected microseismic event information, the seismic signal being received by an array of seismic receivers;
estimating, using the processor, a number of undetected microseismic events and a magnitude for each of the undetected microseismic events to provide undetected microseismic event information, the number of undetected microseismic events and corresponding magnitudes being estimated using each of the detected microseismic events and corresponding magnitudes; and
estimating, using the processor, the stimulated reservoir volume using the detected microseismic event information and the undetected microseismic event information.

The present invention extends to a non-transitory computer readable medium comprising computer executable instructions for estimating a volume of a stimulated reservoir in accordance with the invention of the fourth or fifth aspects in any of their embodiments.

In accordance with a sixth aspect of the invention there is provided a non-transitory computer readable medium comprising computer executable instructions for estimating a volume of a stimulated reservoir that when executed by a computer implements a method comprising:

receiving a seismic signal having a magnitude from each detected microseismic event in a plurality of detected microseismic events in an earth formation to provide detected microseismic event information, the seismic signal being received by an array of seismic receivers;
estimating a number of undetected microseismic events and a magnitude for each of the undetected microseismic events to provide undetected microseismic event information, the number of undetected microseismic events and corresponding magnitudes being estimated using each of the detected microseismic events and corresponding magnitudes; and estimating the stimulated reservoir volume using the detected microseismic event information and the undetected microseismic event information.

The present invention in accordance with the fifth and sixth aspects may include any of the features described by reference to the fourth. In general, the present invention in accordance with any particular aspect may include any or all of the features described by reference to any other aspect of the invention.

Disclosed is a method for estimating a volume of a stimulated reservoir. The method includes: receiving, using a processor, a seismic signal having a magnitude from each detected microseismic event in a plurality of detected microseismic events in an earth formation to provide detected microseismic event information, the seismic signal being received by an array of seismic receivers; estimating, using the processor, a number of undetected microseismic events and a magnitude for each of the undetected microseismic events to provide undetected microseismic event information, the number of undetected microseismic events and corresponding magnitudes being estimated using each of the detected microseismic events and corresponding magnitudes; and estimating, using the processor, the stimulated reservoir volume using the detected microseismic event information and the undetected microseismic event information.

Also disclosed is another method for estimating a volume of a stimulated reservoir. The method includes: stimulating an earth formation using a stimulation apparatus configured to generate a plurality of microseismic events in the formation; receiving, using a processor, a seismic signal having a magnitude from each detected microseismic event in a plurality of detected microseismic events in the earth formation to provide detected microseismic event information, the seismic signal being received by an array of seismic receivers; estimating, using the processor, a number of undetected microseismic events and a magnitude for each of the undetected microseismic events to provide undetected microseismic event information, the number of undetected microseismic events and corresponding magnitudes being estimated using each of the detected microseismic events and corresponding magnitudes; and estimating, using the processor, the stimulated reservoir volume using the detected microseismic event information and the undetected microseismic event information.

Further disclosed is a non-transitory computer readable medium having computer executable instructions for estimating a volume of a stimulated reservoir that when executed by a computer implements a method. The method includes: receiving a seismic signal having a magnitude from each detected microseismic event in a plurality of detected microseismic events in an earth formation to provide detected microseismic event information, the seismic signal being received by an array of seismic receivers; estimating a number of undetected microseismic events and a magnitude for each of the undetected microseismic events to provide undetected microseismic event information, the number of undetected microseismic events and corresponding magnitudes being estimated using each of the detected microseismic events and corresponding magnitudes; and estimating the stimulated reservoir volume using the detected microseismic event information and the undetected microseismic event information.

The invention in any aspect of the invention may include any or all of the features described in relation to any or one aspect of the invention, to the extent they are not mutually exclusive.

The estimated volume of a stimulated reservoir obtained in accordance with some embodiments of the invention may be used in estimating an amount of reservoir hydrocarbons that may be produced.

BRIEF DESCRIPTION OF THE DRAWINGS

The following descriptions should not be considered limiting in any way. With reference to the accompanying drawings, like elements are numbered alike:

FIG. 1 illustrates a cross-sectional view of an exemplary embodiment of an earth formation instrumented to receive microseismic event data;
FIG. 2 depicts aspects of microseismic event detection limits as a function of distance to seismic receivers;
FIG. 3 is a microseismic event magnitude histogram illustrating the population of detected seismic events;
FIGS. 4A-4D, collectively referred to as FIG. 4, depict aspects of quantifying a number of undetected microseismic events and associated magnitudes;
FIG. 5 illustrates a graph of cumulative scalar seismic moment versus moment magnitude;
FIGS. 6A and 6B, collectively referred to as FIG. 6, depict aspects of perturbing the b-value in the Gutenberg-Richter power law relation;
FIG. 7 illustrates microseismic data obtained from local volumes in a reservoir;
FIGS. 8A-8C, collectively referred to as FIG. 8, depict aspects of adding the undetected events back into the microseismic attribute counting and comparing the result with an observed flow rate; and
FIG. 9 is a flow chart for a method for estimating a volume of a stimulated reservoir.

DETAILED DESCRIPTION

A detailed description of one or more embodiments of the disclosed apparatus and method presented herein by way of exemplification and not limitation with reference to the figures.

Disclosed are method and apparatus for estimating a stimulated reservoir volume in an earth formation. The term "stimulated reservoir volume" relates to a volume in an earth formation reservoir that is effectively stimulated, in which the permeability of the volume is increased to allow for a sufficient portion of the fluid being extracted; therefore it will increase the performance (e.g., flow rate) of a well. The stimulated reservoir volume is thus a measure of the efficacy of a stimulus treatment applied to the formation such as fracturing. While the present invention is described with particular reference to estimating a stimulated reservoir volume, the invention may be more broadly applied to estimating a parameter of a subsurface volume.

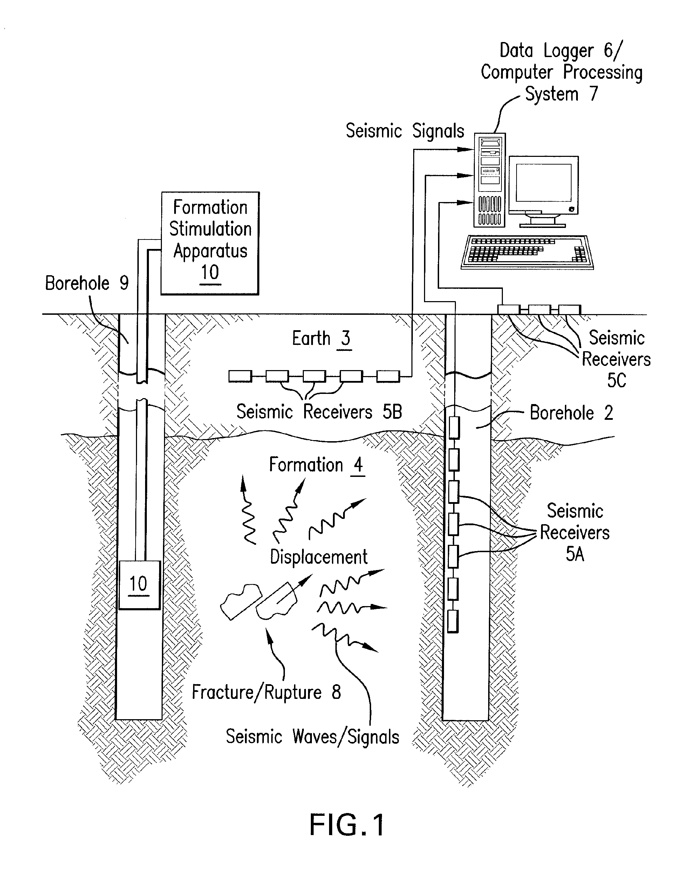

FIG. 1 illustrates a cross-sectional view of an exemplary embodiment of a borehole 2 penetrating the earth 3 having a formation 4. A plurality of seismic transducers or receivers 5 is configured to receive seismic signals and convert them to electrical or optical signals for transmission and/or recording. In the art, seismic receivers may also be referred to as geophones. A plurality of seismic receivers 5A is disposed in the borehole 2. A plurality of seismic receivers 5B is buried shallow in the earth 3 while a plurality of seismic receivers 5C is disposed at the surface of the earth 3. The seismic receivers 5A, B and C are coupled to a data logger 6 that is configured to record a signal magnitude as a function of time for each of the seismic receivers. Functions of the data logger 6 may be performed by a computer processing system 7, which in addition to logging data may process seismic receiver data in accordance with the disclosure herein. It can be appreciated that a microseismic monitoring network can include configurations and combinations of seismic receivers that may differ from the network of receivers illustrated in FIG. 1.

Still referring to FIG. 1, another borehole, a borehole 9, also penetrates the earth 3 and formation 4. A formation stimulus apparatus 10 is disposed in the borehole 9 and configured to stimulate rock in formation 4 such as by fracturing the rock or further opening existing fractures. Non-limiting embodiments of the formation stimulus apparatus are a hydraulic fracturing apparatus and a water injection apparatus.

A location of each or the seismic receivers 5A, B and C is known and together form an array of seismic receivers. When a rupture occurs (i.e. microseismic event) such as at 8 in FIG. 1, a seismic signal or wave is generated and travels in all directions through the formation 4 and/or earth 3 and is received by the array. Because the signal magnitude as a function of time is recorded at each seismic receiver, the signal shape and time of receipt of each signal relative to the other received signals are also known. From this information, metrics characterizing each microseismic event can be determined using known inversion techniques. Inversion relates to mathematical processing that can calculate the metrics of a cause for a resulting event that is measured. In case of the presence of three-directional-component receivers, the directional information of the signal can be derived as well. These techniques may be implemented by the computer processing system 7. In one example, the location of the rupture that would generate the received seismic signal is calculated using inversion techniques.

A seismic event occurs on a fracture or rupture plane, which has an associated area. The relative displacement of this area between two sides of the rupture plane in non-zero. When a rupture occurs, seismic waves are radiated from the rupture through the formation and earth.

The location, magnitude and moment (i.e., mechanical character) of a microseismic event are encoded in the characteristics of the radiated seismic waves. In one or more embodiments, the scalar moment, as defined below, of a microseismic event is derived from the wave magnitude and the wave amplitude spectrum. Other techniques and recorded signals as known in the art may also be used to determine the scalar moment. Further information about each microseismic event may also be obtained from the radiated seismic waves using certain types of receivers, receiver arrays and processing. This further information includes rupture plane size (e.g., rupture area) and orientation along with the displacement of the rupture. This further information and the scalar moment together may be referred to as the moment tensor. In one or more embodiments, the moment tensor may be represented in three-dimensions by a 3 by 3 matrix. Hence, some seismic data available for processing using the methods disclosed herein may include only location and magnitude or scalar moment while other data may include the moment tensor.

Some of the methods for decoding the radiated seismic waves are based measuring a P-wave and an S-wave of the total seismic wave. For the P-wave, the particles in the solid have vibrations along or parallel to the travel direction of the wave energy. For the S-wave, the vibration is perpendicular to the travel direction of the wave energy. The P-wave has higher speed than the corresponding S-wave in the same medium. Noting that it takes a longer time for a seismic signal to reach a receiver that is farther away from a seismic event than a receiver that is closer, the event location can be derived from the arrival time difference of the received P and/or S signals from all receivers or the separation measured between the recorded P-wave and S-wave for the same receiver. Furthermore, the vibration direction will indicate the direction of wave propagation and, therefore, provide information to determine the source location as well. The rupture magnitude or moment magnitude can be derived from the signal amplitude and its travel distance from the source. Additional information may be derived from a Fourier transform of the received seismic signal. In one example, the corner frequency where the slope of the Fourier transform changes suddenly is used to determine the rupture length and source radius, which is an estimate of the rupture size. Information on the size of the rupture plane can be obtained in many ways. The most common ways are either derived from the corner frequency of a waveform amplitude spectrum analysis, or when this is missing, an approximate power law empirical relationship between magnitude and the rupture plane size. As the techniques for analyzing seismic waves to determine fracture metrics, such as rupture location, rupture area, rupture displacement, and rupture plane orientation, using an array of seismic receivers is well known in the art, these techniques are not discussed in further detail.

A plurality of ruptures may be caused in the formation by stimulation such as by hydraulic fracturing or water injection as non-limiting embodiments. Generally, each rupture in the plurality of ruptures occurs at different times. Hence, the location, size and/or orientation of each fracture plane that has ruptured can be determined by the techniques discussed above. All of the ruptured planes together indicate a stimulated rock or reservoir volume.

As disclosed herein, the scalar moment, $M_0 = \mu A D$, is used to describe seismic deformation volume due to fracture or rupture of formation rock where $\mu$ is shear modulus, D is average displacement of the rupture, and A is the area of the rupture. The deformed volume caused by a seismic event (i.e., fracture or rupture) with scalar moment $M_0$ is $\Delta V = AD$ and is used to describe the stimulated rock volume. The scalar seismic moment is one measure of the microseismic event size and energy released. Alternatively, other attributes based on the seismic deformation may also be used.

The aim for using microseismic attributes is to tie these attributes directly to a change in permeability of the reservoir. The permeability change due to stimulation is a direct measure of the efficacy of the stimulation and the resulting permeability is a key parameter for a flow rate calculation. Seismic attributes, which can be used for this purpose, are based on deformation and can be added together based on physics. Non-limiting examples of such attributes are scalar moment, deformed volume and fracture area. The stimulated reservoir volume can be estimated by summing the scalar moment (or other deformation based attribute) for each detected microseismic event and, in addition, summing the estimated scalar moment (or other deformation based attribute) for each of an estimated number of undetected microseismic events.

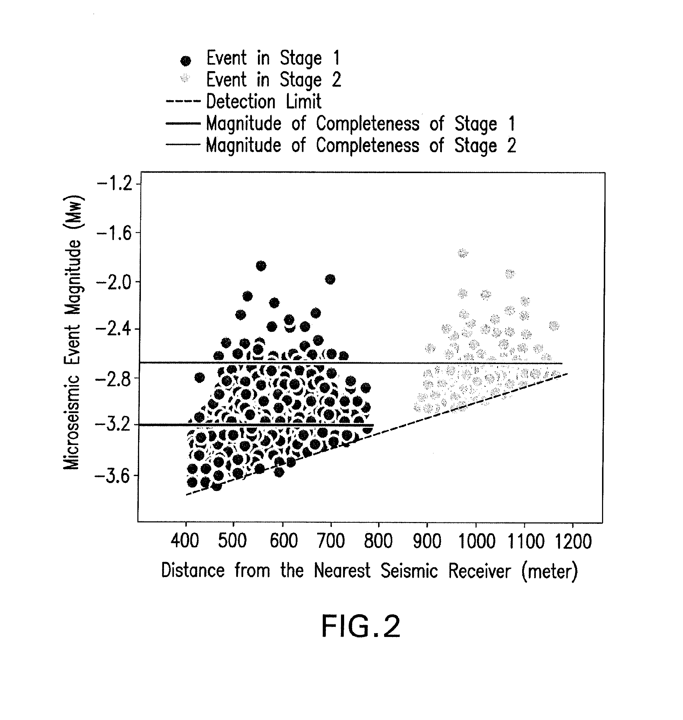

The undetected or missing microseismic events are considered. In a simple case when only one string of downhole vertical receiver array is involved, the event detection limit is often a linear function of the distance of each event from the receiver array as illustrated in FIG. 2 where stage 2 events are further away from the receiver than stage 1 events. With more complicated monitoring arrays, for a given event location, the event detection limit may still have a linear relationship with distance to receivers, but more factors are involved, such as signal to noise ratio difference between surface and downhole receivers. However, from the Gutenberg-Richter law, which relates a number of seismic events that occur to their magnitudes, the number of events and their magnitudes follow a power law relationship. The Gutenberg-Richter law may be written as: $\log(N) = a + b \cdot M_w$ where $M_w$ is the moment magnitude and $a$ and $b$ are coefficients. The moment magnitude may be derived from the magnitude of the seismic signal (e.g., a maximum amplitude and an amplitude spectrum), which may be referred to in the art as the seismograph signal. It can be appreciated that magnitudes other than the moment magnitude may be used in a power law relationship to relate a number of seismic events that occur to their magnitudes. In that determining the moment magnitude from the magnitude of the seismic signal is known in the art, this determination is not discussed in further detail.

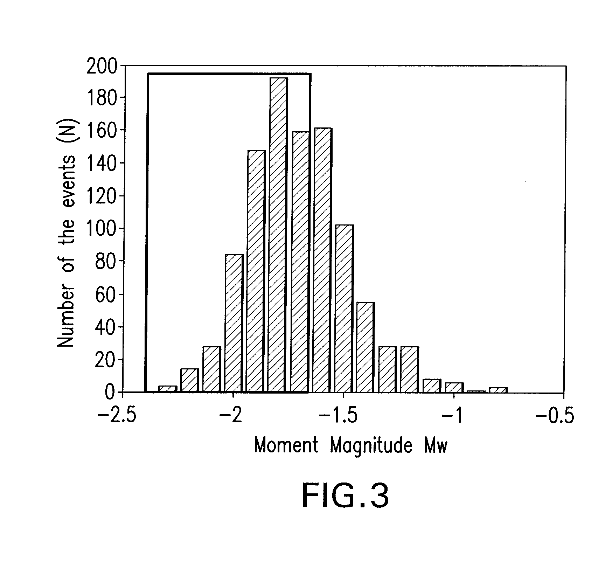

Bigger events with strong seismic signals have a higher likelihood of detection. So a reasonable estimation of undetected events may be made from an event magnitude histogram estimation as illustrated in FIG. 3. Based on this event magnitude histogram, the conclusion may be drawn that the events with magnitude below -1.6 (illustrated in the rectangular box) are not completely detected for this data set because the events below - 1.6 do not follow the power law relationship. The magnitude below which not all microseismic events are detected is referred to herein as the "magnitude of completeness." The phrase "undetected microseismic events" or "undetected events" when used with respect to detected events relates to microseismic events of a certain magnitude onwards towards a lesser magnitude. This is because there are microseismic events, that even though they occur close to a receiver, they cannot be detected either due to their amplitude being below background noise, or due to the event being beyond the receiver's range of sensitivity.

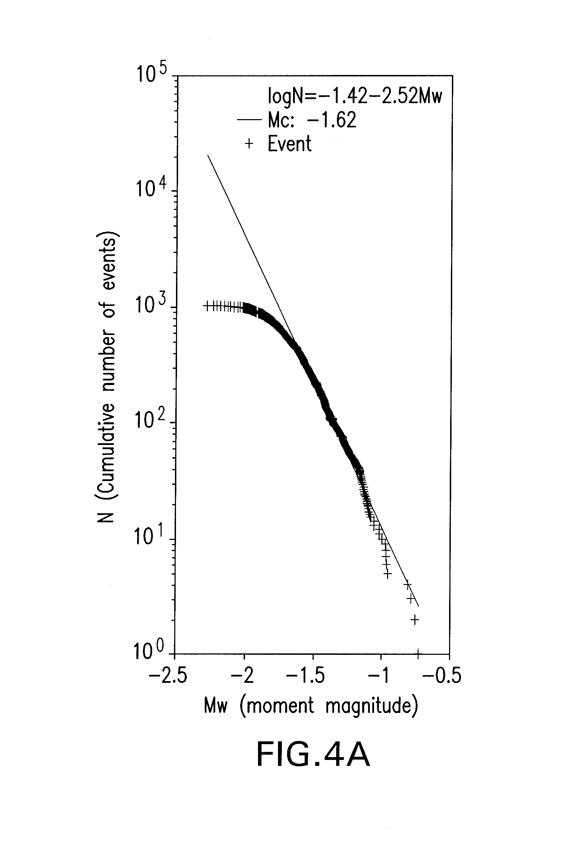

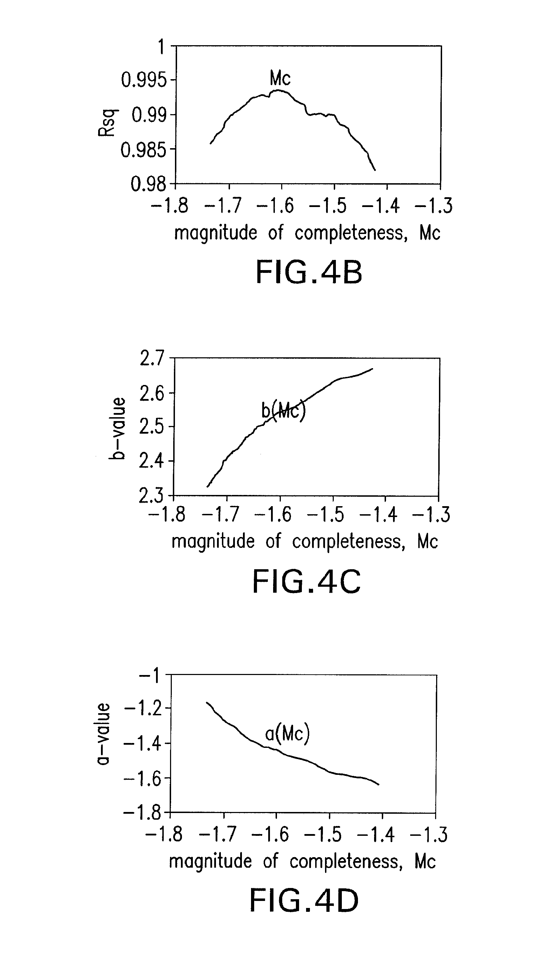

The method disclosed herein provides more accuracy than that provided from a histogram interpretation. The method is based on a statistical best fitting method. Aspects of this method as depicted in FIG. 4. In FIG. 4A, the magnitude of each detected microseismic event and the frequency of occurrence of events having that magnitude or greater magnitude (i.e., the cumulative number of events having that magnitude or greater magnitude) are illustrated. The crosses in this figure indicate data points while the straight line is the prediction of the Gutenberg-Richter power law. The magnitude of completeness occurs approximately where the data departs from the straight line and is - 1.62 for this example. FIG. 4B illustrates the regression of data using the least square method versus the magnitude of completeness. It can be seen that the regression has a maximum value where the magnitude of completeness is -1.62. FIGS. 4C and 4D illustrate the b-value and a-value versus magnitude of completion, respectively. Thus, from these figures the appropriate a and b-values can be selected for the magnitude of completeness of -1.62. Hence by knowing the a and b-values of the Gutenberg-Richter power law, the number of undetected microseismic events and their moment magnitude can be estimated. It can be appreciated that any of several known statistical methods for fitting a curve to data may be used on the whole data set, on only the data above the magnitude of completeness, or on some combination of data above and below the magnitude of completeness.

The cumulative moment may be written as:

$$\sum M_0 = \sum_{Mw} N_{dis}(Mw) * M_0(Mw)$$

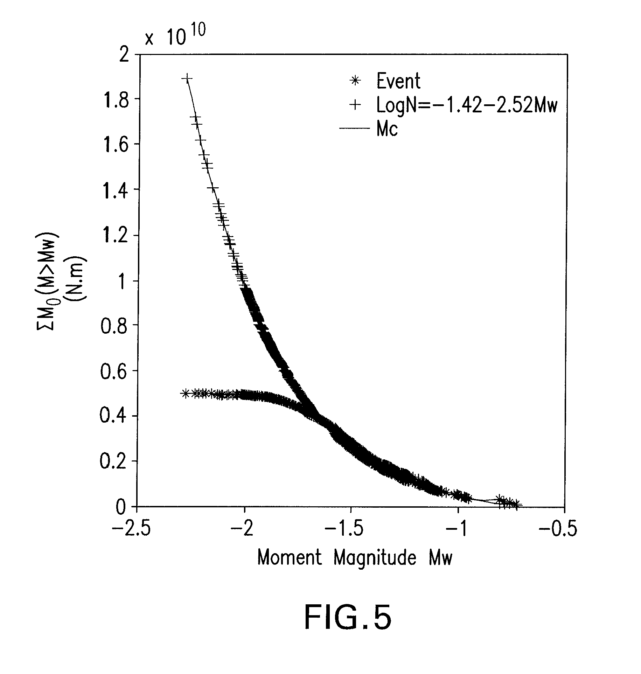

where $M_0$ is the scalar moment in N·m ($10^7$ dyne·cm), $Mw$ is the moment magnitude, and $N_{dis}(Mw)$ is the discrete number of events with that magnitude (i.e., the frequency of occurrence of events with that magnitude). The relationship between the moment magnitude and the scalar moment may be written as: $Mw = (2/3)\log M_0 - 6.0$. Using the same data set that was used in FIG. 4A, the cumulative scalar seismic moment $\Sigma M_0$ versus the moment magnitude is plotted in FIG. 5. It can be seen that approximately 75% of the corrected cumulative seismic moment is from the inferred undetected microseismic events. Hence, by not accounting for the undetected microseismic events, the non- corrected cumulative moment and therefore the efficacy of the stimulation may be significantly underestimated.

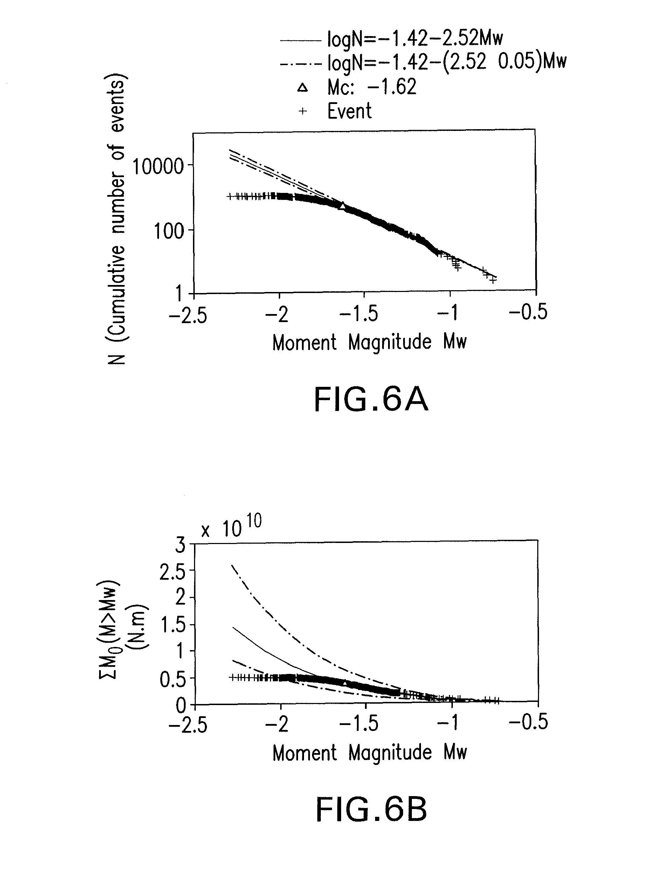

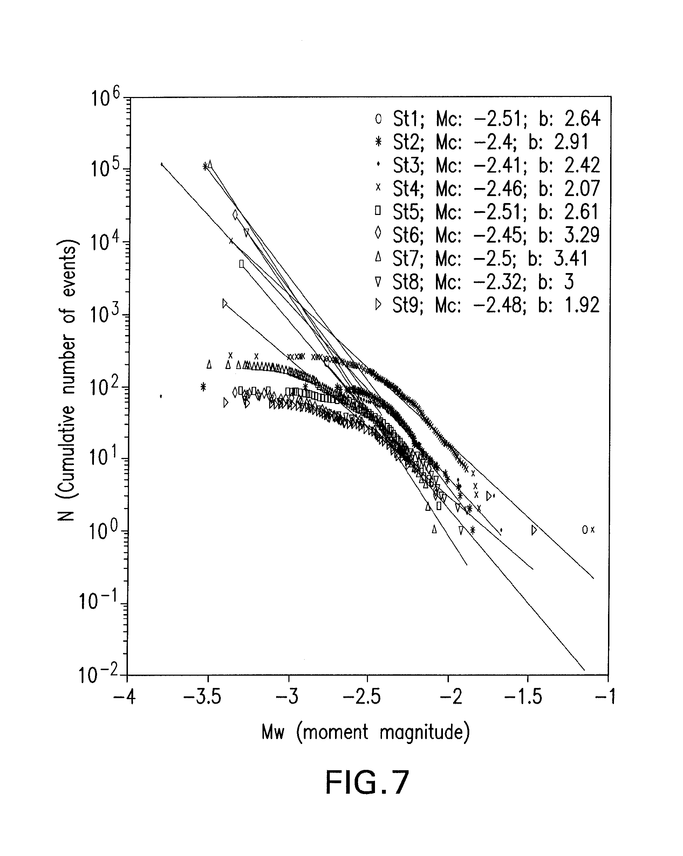

Next, the influence of the b-value on the cumulative scalar seismic moment $\Sigma M_0$ is discussed with reference to FIG. 6. FIG. 6A illustrates the Gutenberg-Richter power law with b-value perturbation of +/- 0.05 and FIG. 6B illustrates the resulting cumulative scalar seismic moment resulting from the perturbation. As can be seen in FIG. 6B, a slight change in the b-value may cause a substantial change in the cumulative scalar moment. If sufficient data is available, then in one or more embodiments the b-value can be determined locally. That is, b-values in reservoir volumes close (i.e., local) to seismic receivers can be determined with improved accuracy, thus accounting for spatial variations in formation properties. If any local data population is too small to determine a local b-value, then a global b-value may be used for that local volume. FIG. 7 illustrates data obtained from nine stimulation treatments referred to as stages (St) where each succeeding stage is approximately 100 meters apart along a horizontal well. The Gutenberg-Richter power law relation is plotted for each of the stages and the magnitude of completeness and the b-value for each stage is listed. The local corrected cumulative scalar seismic moment for each stage, determined with local a and b-values may be used to compare stimulation efficacy between stages, and may be summed to provide the total scalar seismic moment for the total reservoir volume.

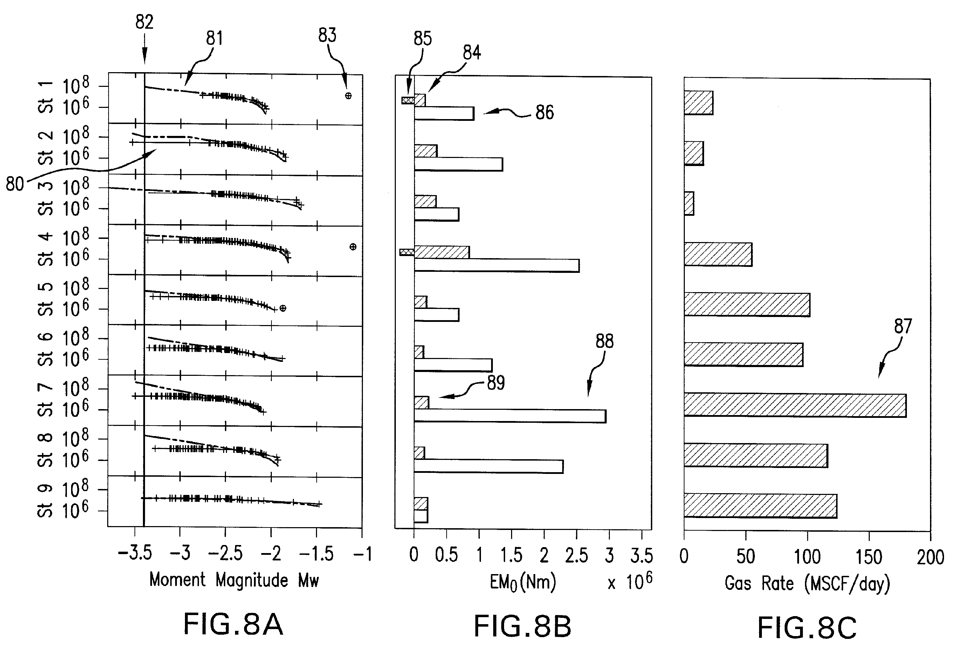

FIG. 8 depicts aspects of adding the undetected events back to the microseismic attributes (e.g., scalar moment) counting, and its added value with respect to the flow rate (or production rate). FIG. 8A illustrates the cumulative scalar moment versus magnitude curves for each stage where the lines 80 with cross markers indicate the detected microseismic data, the dashed lines 81 are estimated cumulative scalar moments from the Gutenberg-Richter coefficients as illustrated in FIG. 7. The vertical line 82 indicates a selected minimum event to start counting for the cumulative scalar moment illustrated in FIG. 8B. The value of the selected minimum event in this example is -3.4 Mw. The circled cross 83 indicates outliers, which are data points with large residuals and/or high leverage. Outliers may distort the outcome and accuracy of the statistical fitting. They can be either automatically identified by calculating a "Cook's distance," by any other known methods, or a subjective choice. FIG. 8B illustrates the cumulative scalar moment in bars for each stage. The upper bars 84 are from the summed attributes from the detected microseismic events. The bars 85 to the left are the outliers, and the lower bars 86 are from the summation of the corrected microseismic events, so the undetected events are accounted for as well. FIG. 8C illustrates the observed production data in "Thousand Standard Cubic Feet (MSCF) per day" for each stage. Looking at stage 7, it can be seen that the bar 88 (where the undetected events are counted) correlate with the observed production data 87 much better than the bar 89 (where the undetected events are not counted).

A physically meaningful way to compare the stimulation efficacy between local volumes and/or stages is to compare them from a unique magnitude threshold onwards toward greater magnitudes. This magnitude threshold can be event magnitude, rupture size, etc. This unique magnitude, due to detection range bias, is often on the high magnitude side as illustrated on right side of FIG. 2 where the upper horizontal line intersects the detection limit line. Thus, the microseismic information provided the lower magnitude range in which only part of the events are detected will be missed. By showing the influence of the b-value and the magnitude of completeness, the energy released by these events below this unique threshold can be substantial and should not be ignored. So in order to push this unique magnitude threshold down, if this unique magnitude is below part or all of the local magnitude of completeness, the missing part is added back accordingly to make the comparison possible. This is supported by the data in FIG. 8.

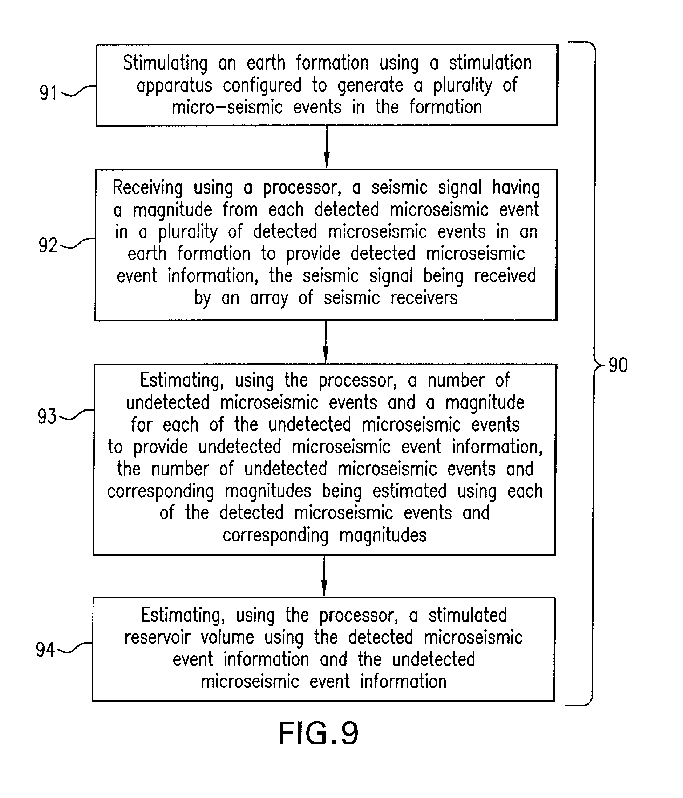

FIG. 9 is a flow chart for a method 90 for estimating a volume of a stimulated reservoir. Block 91 calls for stimulating an earth formation using a stimulation apparatus configured to generate a plurality of microseismic events in the formation. Block 92 calls for receiving, using a processor, a seismic signal having a magnitude from each detected microseismic event in a plurality of detected microseismic events in the earth formation to provide detected microseismic event information, the seismic signal being received by an array of seismic receivers.

The detected microseismic event information may include a location and/or magnitude of each detected microseismic event. Further, block 92 may include determining a scalar attribute, such as moment magnitude ($Mw$), from a magnitude of the seismic signal. Further, block 92 may include calculating a microseismic scalar moment magnitude ($M_0$) as the scalar attribute using the moment magnitude as input.

Block 93 calls for estimating, using the processor, a number of undetected microseismic events and a magnitude for each of the undetected microseismic events to provide undetected microseismic event information. The number of undetected microseismic events and corresponding magnitudes are estimated using each of the detected microseismic events and corresponding magnitudes in the plurality. The undetected microseismic event information may include a number of undetected microseismic events and a corresponding magnitude or moment magnitude ($Mw$) for each of the undetected events. In addition, a scalar attribute, such as a microseismic scalar moment magnitude ($M_0$) may be determined from the moment magnitude for each undetected event. The number of undetected events and the magnitude associated with each undetected event may be estimated from a mathematical relationship that relates a magnitude of a microseismic event to a number of estimated microseismic events having that magnitude or a cumulative number of events at that magnitude or greater magnitude. In one or more embodiments, the mathematical relationship is a power law relationship such as the Gutenberg-Richter power law relationship, although other mathematical relationships may be used. In one or more embodiments, the selected mathematical relationship is fit to the data from the detected microseismic events in the plurality. At a selected range of points on a curve of the mathematical relationship where the data departs the mathematical relationship, the mathematical relationship itself is used to provide the data (i.e., number of undetected events and corresponding magnitudes) for the undetected microseismic events. A threshold value related to determining where the data departs from the mathematical relationship curve (e.g., 2% deviation) may be selected. Alternatively, a statistical best fitting approach such as in FIG. 4 may be used to determine where the data departs from the mathematical relationship based on a selected standard deviation value.

Block 94 calls for estimating, using the processor, the stimulated reservoir volume using the detected microseismic event information and the undetected microseismic event information. Block 94 may include summing the scalar attributes, such as the microseismic scalar moment magnitude ($M_0$), from a selected minimum value onwards, for the detected events and the undetected events in order to estimate the efficacy of the stimulation. In one or more embodiments, a scalar attribute density may also be used. The scalar attribute and/or scalar attribute density of each local volume or stimulation stage provides a measure of the efficacy of stimulation for the corresponding local volume or stimulation stage. The permeability for each local volume or stimulation stage in the stimulated reservoir volume could be made proportional to the scalar attribute or the scalar attribute density of the corresponding local volume or stimulation stage to provide a permeability of the stimulated reservoir volume with spatial or stage variations based on the microseismic event data. Alternatively, the flow rate can be made proportional to the scalar attribute or attribute density when such a relation is more desirable.

It can be appreciated that the method 90 can be performed on local volumes in the earth formation in order to improve the accuracy of the mathematical relationship used to estimate the undetected microseismic events. In this adaptation, the earth formation may be divided into a plurality of grid cells in three-dimensional space. Using the location information derived from the seismic signals received by the array of seismic receivers, the detected events can be assigned to the corresponding grid cells. With the grid cells having assigned events and corresponding magnitudes, the method 90 is applied to the event data in each grid cell separately. By applying the method 90 to each grid cell separately, the mathematical relationship and associated constants and coefficients can be selected to fit the event data of the grid cell to more accurately predict the undetected events in that grid cell. When the method 90 is applied to all the grid cells in the plurality of grid cells, the calculated scalar attribute for each grid cell is estimated by summing all the scalar attributes for the events in each grid cell to provide a grid cell scalar attribute. Accordingly, summing all the grid cell scalar attributes for all grid cells provides an estimate the stimulated reservoir volume. Alternatively, the stimulated reservoir volume may be calculated summing all of the individual scalar attributes of all events throughout the reservoir.

It can be appreciated that location and/or magnitude data from the plurality of detected microseismic events may be plotted or represented "virtually" by a computer processing system without being actually plotted or displayed such as on paper or a computer display. Alternatively or in addition, the data may be plotted and displayed to a user.

The above techniques provide several advantages. One advantage is that a more accurate estimate of the stimulated reservoir volume is provided by accounting for the undetected microseismic events. The accuracy may be further improved by dividing the reservoir into a plurality of grid cells in three-dimensional space and applying the techniques to the individual grid cells in order to account for local differences in the reservoir properties. Further, illustrating the grid cell scalar attribute for each grid cell in three-dimensional space will provide the user with an accurate visual representation of the stimulated reservoir volume.

In support of the teachings herein, various analysis components may be used, including a digital and/or an analog system. For example, the data logger 6, the computer processing system 7, the seismic receivers 5, or the stimulation apparatus 10 may include digital and/or analog systems. The system may have components such as a processor, storage media, memory, input, output, communications link (wired, wireless, pulsed mud, optical or other), user interfaces, software programs, signal processors (digital or analog) and other such components (such as resistors, capacitors, inductors and others) to provide for operation and analyses of the apparatus and methods disclosed herein in any of several manners well-appreciated in the art. It is considered that these teachings may be, but need not be, implemented in conjunction with a set of computer executable instructions stored on a non-transitory computer readable medium, including memory (ROMs, RAMs), optical (CD-ROMs), or magnetic (disks, hard drives), or any other type that when executed causes a computer to implement the method of the present invention. These instructions may provide for equipment operation, control, data collection and analysis and other functions deemed relevant by a system designer, owner, user or other such personnel, in addition to the functions described in this disclosure.

Elements of the embodiments have been introduced with either the articles "a" or "an." The articles are intended to mean that there are one or more of the elements. The terms "including" and "having" are intended to be inclusive such that there may be additional elements other than the elements listed. The conjunction "or" when used with a list of at least two terms is intended to mean any term or combination of terms.

While one or more embodiments have been shown and described, modifications and substitutions may be made thereto without departing from the spirit and scope of the invention. Accordingly, it is to be understood that the present invention has been described by way of illustrations and not limitation.

It will be recognized that the various components or technologies may provide certain necessary or beneficial functionality or features. Accordingly, these functions and features as may be needed in support of the appended claims and variations thereof, are recognized as being inherently included as a part of the teachings herein and a part of the invention disclosed.

While the invention has been described with reference to exemplary embodiments, it will be understood that various changes may be made and equivalents may be substituted for elements thereof without departing from the scope of the invention. In addition, many modifications will be appreciated to adapt a particular instrument, situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

## Claims

1. A method for estimating a parameter of a subsurface volume, the method comprising:

   receiving a seismic signal having an amplitude from each event in a plurality of subsurface events, the seismic signal being received by a seismic receiver;
   estimating undetected events and an attribute for each of the undetected events, the undetected events and corresponding attributes being estimated using the seismic signal and corresponding amplitude; and
   estimating the parameter using the seismic signal and the corresponding attributes of the undetected events;
   wherein each of the estimating undetected events and the estimating the parameter is performed using one or more processors.

2. The method according to claim 1, wherein estimating undetected events comprises selecting a mathematical relationship relating a microseismic event magnitude to a number of microseismic events.

3. The method according to claim 2, wherein the undetected events are estimated from a range of points on a curve of the mathematical relationship where data comprising a number of events and corresponding magnitude received from the seismic signal departs from the curve.

4. The method according to claim 2 or 3, wherein the relationship relates the microseismic event magnitude to a cumulative number of microseismic events occurring at magnitudes that are greater than or equal to the microseismic event magnitude; optionally wherein the relationship comprises:

$$\log(\mathrm{N}) = \mathrm{a} + \mathrm{b}{\cdot}\mathrm{M_w}$$

   where $M_w$ represents a moment magnitude of a microseismic event, N represents a cumulative number of microseismic events having a moment magnitude greater than or equal to $M_w$, a represents a constant, and b represents a coefficient.

5. The method according to any preceding claim, further comprising:

   calculating a scalar attribute for each of the events in the plurality using the amplitude of the corresponding seismic signal; and
   calculating the scalar attribute for each of the estimated undetected events using the estimated attribute; optionally wherein the scalar attribute is a scalar seismic moment ($M_0$).

6. The method according to claim 5, wherein the scalar attribute is a scalar seismic moment ($M_0$), and further comprising:

   determining a moment magnitude ($M_w$) from the magnitude of each of the detected and undetected events; and
   calculating the scalar seismic moment ($M_0$) for each of the detected and undetected events using the corresponding moment magnitude ($M_w$);
   optionally wherein calculating the scalar seismic moment ($M_0$) for each of the detected and undetected events comprises using the following equation:

$$\mathrm{Mw} = (2/3)\mathrm{log}M_0 - 6.0.$$

7. The method according to claim 5 or 6, wherein estimating the parameter comprises summing each of the scalar attributes corresponding to the detected and undetected events.

8. The method according to any preceding claim, further comprising:

   dividing the earth formation into a plurality of grid cells in a three-dimensional space;
   assigning each event to a grid cell based on location information derived from the seismic signal;
   estimating a number of undetected events and a magnitude for each of the undetected events to provide undetected event information for each grid cell, the number of undetected events and corresponding magnitudes for each grid cell being estimated using each of the detected events and corresponding amplitudes assigned to each grid cell;
   calculating a scalar attribute for each of the detected events in each grid cell using the amplitude of the corresponding seismic signal; and
   calculating the scalar attribute for each of the estimated undetected events in each grid cell using the corresponding estimated magnitude.

9. The method according to claim 8, further comprising summing the scalar attributes for each of the detected and undetected events in each grid cell to provide a grid cell scalar attribute.

10. The method according to claim 9, further comprising summing each grid cell scalar attribute for each of the grid cells in the plurality of grid cells to estimate the parameter; and/or further comprising displaying on a display the grid cell scalar attribute for each of the grid cells in the three-dimensional space.

11. The method according to any one of claims 8-10, further comprising summing the scalar attributes for each of the detected and undetected events in each of the grid cells in the plurality of grid cells to estimate the parameter.

12. The method according to any preceding claim, further comprising estimating a permeability of the subsurface volume using the seismic signal and the corresponding attributes of the undetected events, wherein the permeability is proportional to a scalar attribute representing reservoir deformation.

13. The method of any preceding claim further comprising stimulating an earth formation using a stimulation apparatus configured to generate a plurality of events in the formation.

14. A non-transitory computer readable medium comprising computer executable instructions for estimating a parameter of a subsurface volume that when executed by a computer implements a method comprising:

receiving a seismic signal having an amplitude from each event in a plurality of subsurface events, the seismic signal being received by a seismic receiver;
estimating undetected events and an attribute for each of the undetected events, the events and corresponding attributes being estimated using the seismic signal and corresponding amplitudes; and
estimating the parameter using the seismic signal and the corresponding attributes of the undetected events.

15. The method according to any preceding claim, wherein the parameter is a volume of a reservoir; optionally wherein the reservoir is a stimulated reservoir; and/or wherein each event in the plurality of subsurface events is a microseismic event and each undetected event is an undetected microseismic event.

FIG.1

FIG.2

FIG.3

FIG.4A

FIG.4B

FIG.4C

FIG.4D

FIG.5

FIG.6A

FIG.6B

FIG.7

FIG.8A   FIG.8B   FIG.8C

91 — Stimulating an earth formation using a stimulation apparatus configured to generate a plurality of microseismic events in the formation

92 — Receiving using a processor, a seismic signal having a magnitude from each detected microseismic event in a plurality of detected microseismic events in an earth formation to provide detected microseismic event information, the seismic signal being received by an array of seismic receivers

93 — Estimating, using the processor, a number of undetected microseismic events and a magnitude for each of the undetected microseismic events to provide undetected microseismic event information, the number of undetected microseismic events and corresponding magnitudes being estimated using each of the detected microseismic events and corresponding magnitudes

94 — Estimating, using the processor, a stimulated reservoir volume using the detected microseismic event information and the undetected microseismic event information

90

## FIG.9